# EUROPEAN PATENT APPLICATION

(11) **EP 4 325 560 A1**
(43) Date of publication of application: **21.02.2024**
(21) Application number: 23189809.9
(22) Date of filing: 04.08.2023
(51) Int. Cl.: H01L 23/373, H01L 23/538, H01L 25/07

(54) **SEMICONDUCTOR MODULE AND METHOD OF MANUFACTURING THE SAME**

(30) Priority: 12.08.2022 KR 20220101258
(71) Applicant: LX Semicon Co., Ltd., Daejeon 34027 (KR)
(72) Inventor: KIM, Deog Soo, 34027 Daejeon (KR); KIM, Tae Ryong, 34027 Daejeon (KR)
(74) Representative: 2SPL Patentanwälte PartG mbB

(57) **Abstract**

A semiconductor module according to the present disclosure includes a first substrate having a plurality of patterns having two or more different thickness; a first semiconductor device disposed on at least one or more patterns; a second substrate having a plurality of patterns having two or more different thickness, wherein one or more of the plurality of patterns of the second substrate is placed on the first semiconductor device; a first terminal pattern and a second terminal pattern, each disposed between the first substrate and the second substrate, wherein the first terminal pattern comprises a first upper terminal pattern and a first lower terminal pattern, and the second terminal pattern comprises a second upper terminal pattern and a second lower terminal pattern; and a conductive frame coupled to at least one of the first and the second terminal patterns.

## Description

### CROSS-REFERENCE TO RELATED APPLICATIONS

This application claims the benefit of the Korean Patent Application No. 10-2022-0101258 filed on August 12, 2022, which is hereby incorporated by reference as if fully set forth herein.

### BACKGROUND

### Field of the Invention

The present disclosure relates to a semiconductor module, and more specifically, to a semiconductor module having a double-sided heat dissipation structure.

### Discussion of the Related Art

Recently, as the demand for semiconductors increases in various fields, various research and development have been conducted for improving semiconductor functions under specific conditions in addition to main functions of the semiconductors.

Generally, a semiconductor module can include at least one semiconductor device in one package. Specifically, a semiconductor module including a semiconductor device, of which a physical property can be changed by an increase in the amount of heat generated due to a high withstand voltage and a high current, can include a heat dissipation unit for heat dissipation. The semiconductor module including the heat dissipation unit can be classified into a semiconductor module having a single-sided heat dissipation structure and a semiconductor module having a double-sided heat dissipation structure.

Specifically, it is known that the semiconductor module having a double-sided heat dissipation structure can dissipate heat to both upper and lower sides of each semiconductor device and thus is advantageous for a heat dissipation effect.

The semiconductor module having a double-sided heat dissipation structure uses a spacer individually for each semiconductor device for compensation of a thickness deviation between the semiconductor device and a double-sided heat dissipation substrate, forming a space for injection of a molding material, and electrical connection between the semiconductor device and the heat dissipation substrate.

However, when the spacer is used, a problem of misalignment during bonding between the semiconductor device and the spacer can occur, a problem of a bonding failure between the spacer and the double-sided heat dissipation substrate can occur due to height deviations between the spacers, and in addition, since a process of bonding the semiconductor device and the spacer and bonding the spacer and the double-sided heat dissipation substrate is required, there is a problem that the yield is reduced.

### SUMMARY

The present disclosure is directed to providing a semiconductor module including a double-sided heat dissipation substrate capable of securing a space between first and second substrates without using a spacer, and a manufacturing method thereof.

Further, the present disclosure is directed to providing a semiconductor module of which flatness is improved, and a manufacturing method thereof.

A semiconductor module according to one aspect of the present disclosure includes: a first substrate having a plurality of patterns having two or more different thickness; a first semiconductor device disposed on at least one or more patterns; a second substrate having a plurality of patterns having two or more different thickness, wherein one or more of the plurality of patterns of the second substrate is placed on the first semiconductor device; a first terminal pattern and a second terminal pattern, each disposed between the first substrate and the second substrate, wherein the first terminal pattern comprises a first upper terminal pattern and a first lower terminal pattern, and the second terminal pattern comprises a second upper terminal pattern and a second lower terminal pattern; and a conductive frame coupled to at least one of the first and the second terminal patterns.

A semiconductor module according to another aspect of the present disclosure includes: a first substrate having a first lower circuit pattern with a first lower thickness and a second lower circuit pattern with a second lower thickness different from the first lower thickness, the first lower circuit pattern and the second lower circuit pattern being formed on a first surface of the first substrate; a second substrate disposed to face the first surface of the first substrate, and having a first upper circuit pattern with a first upper thickness and a second upper circuit pattern with a second upper thickness, the first upper circuit pattern being formed in a region corresponding to the first lower circuit pattern on a first surface of the second substrate and the second upper circuit pattern being formed in a region corresponding to the second lower circuit pattern on the first surface of the second substrate; a first semiconductor device disposed between the first lower circuit pattern and the first upper circuit pattern, and having a first surface, on which a first electrode is formed, electrically connected to the first lower circuit pattern, and a second surface, on which a second electrode is formed, electrically connected to the first upper circuit pattern; and a second semiconductor device disposed between the second lower circuit pattern and the second upper circuit pattern, and having a first surface, on which the first electrode is formed, electrically connected to the second upper circuit pattern, and a second surface, on which the second electrode is formed, electrically connected to the second lower circuit pattern.

A method of fabricating a semiconductor module according to still another aspect of the present disclosure includes: preparing a first substrate and a second substrate, wherein the first substrate comprises a first surface on which a first conductive layer is formed and a second surface on which a first heat dissipation layer is formed, and the second substrate comprises a first surface on which a second conductive layer is formed and a second surface on which a second heat dissipation layer is formed; forming a first lower circuit pattern with a first lower thickness and a second lower circuit pattern with a second lower thickness on the first surface of the first substrate by selectively etching the first conductive layer; forming a first upper circuit pattern with a first upper thickness in a region corresponding to the first lower circuit pattern and a second upper circuit pattern with a second upper thickness in a region corresponding to the second lower circuit pattern on a first surface of a second substrate by selectively etching the second conductive layer; disposing the first and the second substrates so that each of the first surfaces of the first and the second substrates faces each other; bonding a first semiconductor device to the first lower circuit pattern and the first upper circuit pattern using a first lower conductive bonding member and a first upper conductive bonding member; and bonding a second semiconductor device to the second lower circuit pattern and the second upper circuit pattern using a second lower conductive bonding member and a second upper conductive bonding member.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a view schematically illustrating a semiconductor module having a double-sided heat dissipation structure according to one embodiment of the present disclosure;
FIG. 2 is a view schematically illustrating a configuration of a semiconductor device according to one embodiment of the present disclosure;
FIGS. 3 to 5 are views schematically illustrating semiconductor modules having double-sided heat dissipation structures according to other embodiments of the present disclosure;
FIG. 6 is a circuit diagram of a power device configured using the semiconductor module according to one embodiment of the present disclosure; and
FIGS. 7A to 7D are schematic cross-sectional views of a process illustrating a method of manufacturing a semiconductor module having a double-sided heat dissipation structure according to one embodiment of the present disclosure.

### DETAILED DESCRIPTION OF THE DISCLOSURE

In the specification, it should be noted that like reference numerals already used to denote like elements in other drawings are used for elements wherever possible. In the following description, when a function and a configuration known to those skilled in the art are irrelevant to the essential configuration of the present disclosure, their detailed descriptions will be omitted. The terms described in the specification should be understood as follows.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present specification are used, another part may be added unless 'only∼' is used. The terms of a singular form may include plural forms unless referred to the contrary.

In construing an element, the element is construed as including an error range although there is no explicit description.

In describing a positional relationship, for example, when the positional relationship between two parts is described as 'on∼', 'above∼', 'under∼', 'on the side of~', etc., one or more other parts may be located between the two parts unless 'right' or 'direct' are used.

In describing a time relationship, for example, when the temporal order is described as 'after~', 'subsequent~', 'next~', and 'before~', a case which is not continuous may be included unless 'just' or 'direct' is used.

It will be understood that, although the terms "first", "second", etc. may be used herein to describe various elements, these elements should not be limited by these terms. These terms are only used to distinguish one element from another. For example, a first element could be termed a second element without departing from the scope of the present disclosure.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various embodiments of the present disclosure may be partially or overall coupled to or combined with each other, and may be variously inter-operated with each other and driven technically as those skilled in the art can sufficiently understand. The embodiments of the present disclosure may be carried out independently from each other, or may be carried out together in co-dependent relationship.

Hereinafter, embodiments of the present disclosure will be described in detail with reference to the accompanying drawings.

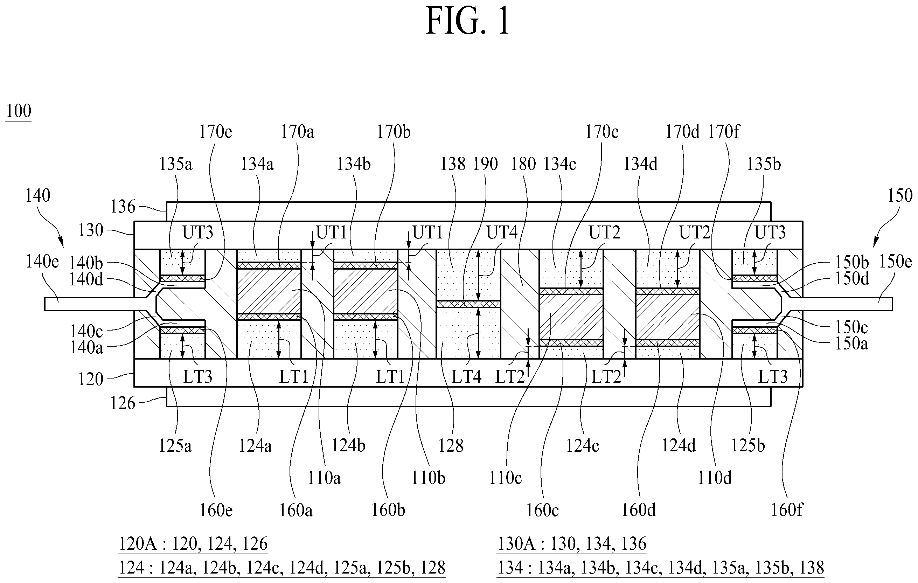

FIG. 1 is a view schematically illustrating a semiconductor module having a double-sided heat dissipation structure according to one embodiment of the present disclosure. As shown in FIG. 1, a semiconductor module 100 having a double-sided heat dissipation structure according to one embodiment of the present disclosure includes one or more semiconductor devices 110a to 110d, a first heat dissipation substrate 120A, a second heat dissipation substrate 130A, and lead frames 140 and 150.

Each of the semiconductor devices 110a to 110d refer to a semiconductor device manufactured through a wafer-level process. In one embodiment, a semiconductor device included in each of the semiconductor devices 110a to 110d may be a power semiconductor device. The power semiconductor device may perform an operation of converting power supplied from a power supply such as a battery or the like to power for driving a motor through a switching operation and supplying the converted power.

For example, each of the semiconductor devices 110a to 110d may include a power semiconductor device such as a gate turn-off thyristor (GTO), an insulated gate bipolar transistor (IGBT), or a metal oxide semiconductor field effect transistor (MOSFET), or a semiconductor device such as a diode.

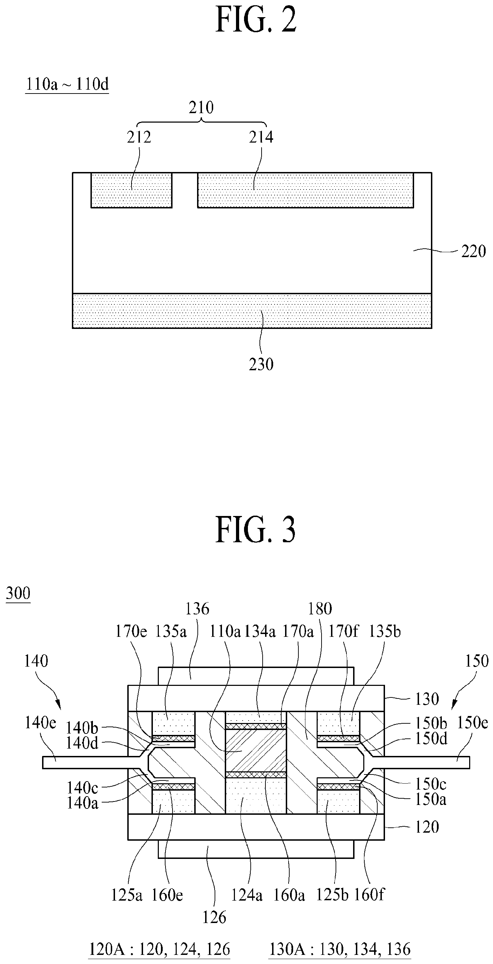

Hereinafter, a configuration of each of the semiconductor devices 110a to 110d according to the present disclosure will be described in more detail with reference to FIG. 2.

FIG. 2 is a view schematically illustrating the configuration of the semiconductor device according to one embodiment of the present disclosure. As shown in FIG. 2, each of the semiconductor devices 110a to 110d according to one embodiment of the present disclosure includes a first electrode 210, a semiconductor layer 220, and a second electrode 230.

The first electrode 210 is disposed on the semiconductor layer 220. In one embodiment, when each of the semiconductor devices 110a to 110d includes a power semiconductor device such as a MOSFET, the first electrode 210 may include a gate electrode 212 and a source electrode 214. In this case, the gate electrode 212 and the source electrode 214 are formed to be electrically isolated from each other. As another example, when each of the semiconductor devices 110a to 110d includes a power semiconductor device such as an IGBT, the first electrode 210 may include the gate electrode 212 and an emitter electrode 214. In this case, the gate electrode 212 and the emitter electrode 214 are formed to be electrically isolated from each other.

The second electrode 230 is disposed under the semiconductor layer 220. In one embodiment, when each of the semiconductor devices 110a to 110d includes the power semiconductor device such as the MOSFET, the second electrode 230 may include a drain electrode. As another example, when each of the semiconductor devices 110a to 110d includes the power semiconductor device such as the IGBT, the second electrode 230 may include a collector electrode.

In the above-described embodiment, the first electrode 210 may be composed of an Al-based metal, and the second electrode 230 may be composed of a Ti/Ni/Ag metal including a Ti layer, a Ni layer, and an Ag layer, NiV/Ag, V (vanadium)/Ni/Ag, or the like, and the semiconductor layer 220 may be composed of silicon carbide (SiC).

In one embodiment, the semiconductor devices 110a to 110d may include the same type of semiconductor devices. For example, all of the first to fourth semiconductor devices 110a to 110d may include transistors. As another example, some of the semiconductor devices 110a to 110d may be implemented with different types of semiconductor devices. For example, the first and fourth semiconductor devices 110a and 110d may include transistors, and the second and third semiconductor devices 110b and 110c may include diodes.

Hereinafter, for convenience of description, a case in which it is assumed that all of the first to fourth semiconductor devices 110a to 110d include the same type of semiconductor devices will be described.

As shown in FIG. 1, the first to fourth semiconductor devices 110a to 110d are disposed between the first and second substrates 120 and 130. In this case, the first and second semiconductor devices 110a and 110b may be disposed so that the first electrodes 210 may face a lower side and the second electrodes 230 may face an upper side. Further, the third and fourth semiconductor devices 110c and 110d may be disposed so that the first electrodes 210 may face an upper side and the second electrodes 230 may face a lower side.

This is to allow the second electrode 230 of the first semiconductor device 110a and the first electrode 210 of the fourth semiconductor device 110d to be electrically connected so that the first and fourth semiconductor devices 110a and 110d are serially connected to each other, and the second electrode 230 of the second semiconductor device 110b and the first electrode 210 of the third semiconductor device 110c to be electrically connected so that the second and third semiconductor devices 110b and 110c are serially connected to each other.

In this case, since the first electrodes 210 of the first and second semiconductor devices 110a and 110b are electrically connected to each other and the second electrodes 230 of the first and second semiconductor devices 110a and 110b are electrically connected to each other, the first and second semiconductor devices 110a and 110b may be connected in parallel. Further, since the first electrodes 210 of the third and fourth semiconductor devices 110c and 110d are electrically connected to each other and the second electrodes 230 of the third and fourth semiconductor devices 110c and 110d are electrically connected to each other, the third and fourth semiconductor devices 110c and 110d may be connected in parallel

In another embodiment, all of the first to fourth semiconductor devices 110a to 110d may be disposed between the first and second substrates 120 and 130 so that the same electrodes face the same direction. For example, all of the first electrodes 210 of the first to fourth semiconductor devices 110a to 110d may be disposed to face the upper side, and all of the second electrodes 230 of the first to fourth semiconductor devices 110a to 110d may be disposed to face the lower side. As another example, all of the first electrodes 210 of the first to fourth semiconductor devices 110a to 110d may be disposed to face the lower side, and all of the second electrodes 230 of the first to fourth semiconductor devices 110a to 110d may be disposed to face the upper side.

Hereinafter, for convenience of description, it is described that the first and second semiconductor devices 110a and 110b are disposed so that the first electrodes 210 face the lower side and the second electrodes 230 face the upper side, and the third and fourth semiconductor devices 110c and 110d are disposed so that the first electrodes 210 face the upper side and the second electrodes 230 face the lower side.

The first heat dissipation substrate 120A is disposed under the semiconductor devices 110a to 110d to dissipate heat generated from the semiconductor devices 110a to 110d to the outside of the first heat dissipation substrate 120A. In one embodiment, the first heat dissipation substrate 120A may include the first substrate 120 formed of an insulating material. The second heat dissipation substrate 130A is disposed above the semiconductor devices 110a to 110d to dissipate heat generated from the semiconductor devices 110a to 110d to the outside of the second heat dissipation substrate 130A. In one embodiment, the second heat dissipation substrate 130A may include the second substrate 130 formed of an insulating material. The first substrate 120 and the second substrate 130 may be formed of a material having an excellent thermal conductivity and an excellent electrical insulation property. In one embodiment, the first substrate 120 and the second substrate 130 may be formed of a ceramic material such as Al₂O₃, AlN, ZTA, Si₃N₄, or the like.

A first circuit line layer 124 is formed on one surface of the first substrate 120, for example, on an upper surface of the first substrate 120, and a first heat dissipation layer 126 is formed on an opposite surface of the first substrate 120, for example, on a lower surface of the first substrate 120.

The first circuit line layer 124 includes a plurality of lower circuit patterns 124a to 124d and a plurality of lower terminal patterns 125a and 125b, and is electrically connected to the electrodes of the semiconductor devices 110a to 110d or the conductive lead frames 140 and 150. The lower circuit patterns 124a to 124d and the lower terminal patterns 125a and 125b included in the first circuit line layer 124 may be formed to have different thicknesses. In one embodiment, the lower circuit patterns 124a to 124d may be formed with thicknesses which are different for each position according to the thickness difference between the semiconductor devices 110a to 110d.

Specifically, as shown in FIG. 1, the plurality of lower circuit patterns 124a to 124d include a first lower circuit pattern 124a, a second lower circuit pattern 124b, a third lower circuit pattern 124c, and a fourth lower circuit pattern 124d. The lower terminal patterns 125a and 125b include a first lower terminal pattern 125a and a second lower terminal pattern 125b.

The first lower circuit pattern 124a is connected to the first electrode 210 of the first semiconductor device 110a. The second lower circuit pattern 124b is connected to the first electrode 210 of the second semiconductor device 110b. The first and second lower circuit patterns 124a and 124b are formed to have a first lower thickness LT1. The third lower circuit pattern 124c is connected to the second electrode 230 of the third semiconductor device 110c. The fourth lower circuit pattern 124d is connected to the second electrode 230 of the fourth semiconductor device 110d. The third and fourth lower circuit patterns 124c and 124d may be formed to have a second lower thickness LT2 different from the first lower thickness LT1.

The first lower terminal pattern 125a is connected to the first lead frame 140 among the lead frames 140 and 150. The second lower terminal pattern 125b is connected to the second lead frame 150. The first and second lower terminal patterns 125a and 125b may be formed to have a third lower thickness LT3 different from the first lower thickness LT1 and the second lower thickness LT2.

In one embodiment, the first lower thickness LT1, the second lower thickness LT2, and the third lower thickness LT3 may be varied depending on the interval between the first substrate 120 and the second substrate 130 and the thicknesses of the first to fourth semiconductor devices 110a to 110d. The first lower thickness LT1 of the first and second lower circuit patterns 124a and 124b may be greater than the second lower thickness LT2 of the third and fourth lower circuit patterns 124c and 124d, and the third lower thickness LT3 of the first and second lower terminal patterns 125a and 125b may be smaller than the first lower thickness LT1 and greater than the second lower thickness LT2.

Like the above, in the present disclosure, by removing the existing spacer disposed between the first substrate 120 and the second substrate 130 and adjusting the thicknesses of the lower circuit patterns 124a to 124d and the lower terminal patterns 125a and 125b formed on the first substrate 120, problems due to an existing spacer, such as a flatness problem, a misalignment problem, an bonding failure problem, and the like may be solved.

In one embodiment, the first lower circuit pattern 124a is coupled to the first electrode 210 of the first semiconductor device 110a through a first lower bonding member 160a, and the second lower circuit pattern 124b is coupled to the first electrode 210 of the second semiconductor device 110b through a second lower bonding member 160b. Further, the third lower circuit pattern 124c is connected to the second electrode 230 of the third semiconductor device 110c through a third lower bonding member 160c, and the fourth lower circuit pattern 124d is connected to the second electrode 230 of the fourth semiconductor device 110d through a fourth lower bonding member 160d. In addition, the first lower terminal pattern 125a is coupled to the first lead frame 140 through a fifth lower bonding member 160e, and the second lower terminal pattern 125b is connected to the second lead frame 150 through a sixth lower bonding member 160f.

Like the above, in the case of the present disclosure, since the semiconductor devices 110a to 110d and the first lower circuit patterns 124a to 124d are directly coupled through the lower bonding members 160a to 160d without a separate spacer, a crack problem which occurs due to coefficient of thermal expansion (CTE) mismatching between the existing spacer and the bonding members may be prevented in advance. Further, since bonding members for bonding the semiconductor devices and the spacer are not required, a manufacturing process of the semiconductor module is simplified, the structure of the semiconductor module is simplified, and the manufacturing cost of the semiconductor module is reduced, and thus productivity is improved.

The first heat dissipation layer 126 may be formed on a lower surface of the first substrate 120. The first heat dissipation layer 126 may contact with the first substrate 120 through one surface thereof and may dissipate heat to the other surface thereof. A heat dissipation unit including a cooling medium may be disposed on the other surface of the first heat dissipation layer 126.

In the above-described embodiment, the first circuit line layer 124 and the first heat dissipation layer 126 may be formed of a copper-based metal.

A second circuit line layer 134 is formed on one surface of the second substrate 130, for example, a lower surface of the second substrate 130 with reference to FIG. 1, and a second heat dissipation layer 136 is formed on an opposite surface of the second substrate 130, for example, an upper surface of the second substrate 130 with reference to FIG. 1.

The second circuit line layer 134 includes a plurality of upper circuit patterns 134a to 134d and a plurality of upper terminal patterns 135a and 135b, and is electrically connected to the electrodes of the semiconductor devices 110a to 110d or the lead frames 140 and 150. The upper circuit patterns 134a to 134d and the upper terminal patterns 135a and 135b included in the second circuit line layer 134 may be formed to have different thicknesses. In one embodiment, the upper circuit patterns 134a to 134d may be formed with thicknesses which are different for each position according to the thickness difference between the semiconductor devices 110a to 110d.

Specifically, as shown in FIG. 1, the plurality of upper circuit patterns 134a to 134d include a first upper circuit pattern 134a, a second upper circuit pattern 134b, a third upper circuit pattern 134c, and a fourth upper circuit pattern 134d, and the upper terminal patterns 135a and 135b include a first upper terminal pattern 135a and a second upper terminal pattern 135b.

In this case, on a first surface of the second substrate 130, the first upper circuit pattern 134a is formed in a region corresponding to the first lower circuit pattern 124a, the second upper circuit pattern 134b is formed in a region corresponding to the second lower circuit pattern 124b, the third upper circuit pattern 134c is formed in a region corresponding to the third lower circuit pattern 124c, and the fourth upper circuit pattern 134d is formed in a region corresponding to the fourth lower circuit pattern 124d. Further, on the first surface of the second substrate 130, the first upper terminal pattern 135a is formed in a region corresponding to the first lower terminal pattern 125a, and the second upper terminal pattern 135b is formed in a region corresponding to the second lower terminal pattern 125b.

The first upper circuit pattern 134a is connected to the second electrode 230 of the first semiconductor device 110a, and the second upper circuit pattern 134b is connected to the second electrode 230 of the second semiconductor device 110b. The first and second upper circuit patterns 134a and 134b are formed to have the first upper thickness UT1. The third upper circuit pattern 134c is connected to the first electrode 210 of the third semiconductor device 110c, and the fourth upper circuit pattern 134d is connected to the first electrode 210 of the fourth semiconductor device 110d. The third and fourth upper circuit patterns 134c and 134d may be formed to have the second upper thickness UT2.

The first upper terminal pattern 135a is connected to the first lead frame 140 among the lead frames 140 and 150. The second upper terminal pattern 135b is connected to the second lead frame 150. The first and second upper terminal patterns 135a and 135b may be formed to have the third upper thickness UT3.

In one embodiment, the first upper thickness UT1, the second upper thickness UT2, and the third upper thickness UT3 may be varied depending on the interval between the first substrate 120 and the second substrate 130 and the thicknesses of the first to fourth semiconductor devices 110a to 110d. The first upper thickness UT1 of the first and second upper circuit patterns 134a and 134b may be smaller than the second upper thickness UT2 of the third and fourth upper circuit patterns 134c and 134d, and the third upper thickness UT3 of the first and second upper terminal patterns 135a and 135b may be smaller than the first upper thickness UT1 and greater than the second upper thickness UT2.

Specifically, according to the present disclosure, the second lower thickness LT2 and the second upper thickness UT2 may determined so that the sum of the second lower thickness LT2 and the second upper thickness UT2 is equal to the sum of the first lower thickness LT1 and the first upper thickness UT1. For, example, the second lower thickness LT2 may be determined to be equal to the first upper thickness UT1, and the second upper thickness UT2 may be determined to be equal to the first lower thickness LT1.

Like the above, in the present disclosure, the interval between the first substrate 120 and the second substrate 130 may be maintained constant by adjusting the thicknesses of the lower circuit patterns 124a to 124d, the upper circuit patterns 134a to 134d, the lower terminal patterns 125a and 125b, and the upper terminal patterns 135a and 135b depending on the thicknesses of the semiconductor devices 110a to 110d.

In this case, in order to maintain the interval between the first and second substrates 120 and 130 constant in all positions, the first lower circuit pattern 124a with the first lower thickness LT1 and the first upper circuit pattern 134a with the first upper thickness UT1 are disposed with the first semiconductor device 110a therebetween, and the second lower circuit pattern 124b with the first lower thickness LT1 and the second upper circuit pattern 134b with the first upper thickness UT1 are disposed with the second semiconductor device 110b therebetween. Further, the third lower circuit pattern 124c with the second lower thickness LT2 and the third upper circuit pattern 134c with the second upper thickness UT2 are disposed with the third semiconductor device 110c therebetween, and the fourth lower circuit pattern 124d with the second lower thickness LT2 and the fourth upper circuit pattern 134d with the second upper thickness UT2 are disposed with the fourth semiconductor device 110d therebetween.

In one embodiment, the first upper circuit pattern 134a is coupled to the second electrode 230 of the first semiconductor device 110a through a first upper bonding member 170a, and the second upper circuit pattern 134b is coupled to the second electrode 230 of the second semiconductor device 110b through a second upper bonding member 170b. Further, the third upper circuit pattern 134c is coupled to the first electrode 210 of the third semiconductor device 110c through a third upper bonding member 170c, and the fourth upper circuit pattern 134d is coupled to the first electrode 210 of the fourth semiconductor device 110d through a fourth upper bonding member 170d. In addition, the first upper terminal pattern 135a is coupled to the first lead frame 140 through a fifth upper bonding member 170e, and the second upper terminal pattern 135b is coupled to the second lead frame 150 through a sixth upper bonding member 170f.

In the above-described embodiment, the first to sixth lower bonding members 160a to 160f and the first to sixth upper bonding members 170a to 170f may be composed of an Sn-Ag-based material or an Ag-based material.

The second heat dissipation layer 136 may be formed on an upper surface of the second substrate 130. The second heat dissipation layer 136 may contact with the second substrate 130 through one surface thereof and may dissipate heat to the other surface thereof. A heat dissipation unit including a cooling medium may be disposed on the other surface of the second heat dissipation layer 136.

In the above-described embodiment, the second circuit line layer 134 and the second heat dissipation layer 136 may be formed of a copper-based metal.

Like the above, in the present disclosure, the thicknesses of the lower circuit patterns 124a to 124d, the upper circuit patterns 134a to 134d, the lower terminal patterns 125a and 125b, and the upper terminal patterns formed on the first and second substrates 120 and 130 is increased and the thickness of each pattern is differently adjusted depending on a region where each pattern is located to remove the existing spacer. Thus, the problems due to the existing spacer disposed between the first substrate 120 and the second substrate 130, such as a flatness problem, a misalignment problem, a bonding failure problem, and the like may be solved.

Further, in the case of the present disclosure, since first surfaces of the first to fourth semiconductor devices 110a to 110d and the lower circuit patterns 124a to 124d are directly coupled through the lower bonding members 160a to 160d, and second surfaces of the first to fourth semiconductor devices 110a to 110d and the upper circuit patterns 134a to 134d are directly bonded through the upper bonding members 170a to 170d without a separate spacer, the crack problem which occurs due to the CTE mismatching between the existing spacer and the bonding members may be prevented in advance. Further, since bonding members for bonding the semiconductor devices and the spacer are also not required, a manufacturing process of the semiconductor module 100 is simplified, the structure of the semiconductor module 100 is simplified, and the manufacturing cost of the semiconductor module 100 is reduced, and thus productivity is improved.

In the above-described embodiment, when the semiconductor devices 110a to 110d are changed, since the flatness may be adjusted by adjusting only the thicknesses of the lower circuit patterns 124a to 124d, the upper circuit patterns 134a to 134d, the lower terminal patterns 125a and 125b, and the upper terminal patterns 135a and 135b, a step difference due to a thickness deviation between the semiconductor devices 110a to 110d may be corrected.

In one embodiment, the first heat dissipation substrate 120A and the second heat dissipation substrate 130A may be formed using any one of a direct bonded copper (DBC) method, an active material brazing (AMB) method, and a direct plating copper (DPC) method.

The lead frames 140 and 150 electrically connect the semiconductor module 100 to an external load. The lead frames 140 and 150 include the first lead frame 140 and the second lead frame 150.

In the first lead frame 140, one end may be connected to the semiconductor module 100, and the other end may be exposed to the outside of the semiconductor module 100 to be electrically connected to an external load such as a motor, an input power source, an inverter controller, or the like.

The first lead frame 140 is composed of a first branch 140a, a second branch 140b, a first connection branch 140c, a second connection branch 140d, and a third branch 140e. The first branch 140a is coupled to the first lower terminal pattern 125a through the fifth lower bonding member 160e, and the second branch 140b is coupled to the first upper terminal pattern 135a through the fifth upper bonding member. 170e. In one embodiment, the first branch 140a and the second branch 140b may be formed to be spaced apart from each other at a predetermined interval in a direction perpendicular to the first and second substrates 120 and 130, and a molding member 180 is formed in a space between the first branch 140a and the second branch 140b by injecting a molding material. In this case, a separation distance between the first and second branches 140a and 140b may be adjusted according to the thickness of the first lower terminal pattern 125a, the thickness of the first upper terminal pattern 135a, a required interval between the first and second substrates 120 and 130, and the like.

Like the above, according to the present disclosure, since the thicknesses of the first lower terminal pattern 125a and the first upper terminal pattern 135a to which the first and second branches 140a and 140b are connected may be reduced by forming the first and second branches 140a and 140b so that the first and second branches 140a and 140b are spaced apart from each other at the predetermined interval, the production cost of the semiconductor module 100 may be reduced.

The first connection branch 140c connects one end of the first branch 140a and one end of the third branch 140e, and the second connection branch 140d connects one end of the second branch 140b and one end of the third branch 140e. In one embodiment, the first and second connection branches 140c and 140d may be formed as inclined surfaces each having a predetermined inclination. Since an amount of the molding material to be injected in the space between the first branch 140a and the second branch 140b to form the molding member 180 may be increased by forming the first and second connection branches 140c and 140d as the inclined surfaces, an insulation property between the first and second heat dissipation substrates 120A and 130A may be increased.

The one end of the third branch 140e is connected to each of the first and second branches 140a and 140b through the first and second connection branches 140c and 140d, and the other end is electrically connected to an external load.

In the above-described embodiment, it is described that the first lead frame 140 includes the first branch 140a and the second branch 140b, but in the modified embodiment, the first lead frame 140 may include only one of the first branch 140a and the second branch 140b. In this case, the first lead frame 140 may be electrically connected to either the first substrate 120 or the second substrate 130 through the first branch 140a or the second branch 140b. When the first lead frame 140 includes only the first branch 140a, the second connection branch 140d may be omitted, and when the first lead frame 140 includes only the second branch 140b, the first connection branch 140c may be omitted.

In the second lead frame 150, one end may be connected to the semiconductor module 100, and the other end may be exposed to the outside of the semiconductor module 100 to be electrically connected to the external load such as a motor, an input power source, an inverter controller, or the like.

The second lead frame 150 is composed of a first branch 150a, a second branch 150b, a first connection branch 150c, a second connection branch 150d, and a third branch 150e like the first lead frame 140. The first branch 150a is coupled to the second lower terminal pattern 125b through the sixth lower bonding member 160f, and the second branch 150b is coupled to the second upper terminal pattern 135b through the sixth upper bonding member 170f. In one embodiment, the first branch 150a and the second branch 150b may be formed to be spaced apart from each other at a predetermined interval in the direction perpendicular to the first and second substrates 120 and 130, and a molding member 180 is formed in a space between the first branch 150a and the second branch 150b by injecting a molding material. In this case, a separation distance between the first and second branches 150a and 150b may be adjusted depending on the thickness of the second lower terminal pattern 125b, the thickness of the second upper terminal pattern 135b, the required interval between the first and second substrates 120 and 130, and the like.

Like the above, according to the present disclosure, since the thicknesses of the second lower terminal pattern 125b and the second upper terminal pattern 135b to which the first and second branches 150a and 150b are connected may be reduced by forming the first and second branches 150a and 150b so that the first and second branches 150a and 150b are spaced apart from each other at the predetermined interval, the production cost of the semiconductor module 100 may be reduced.

The first connection branch 150c connects one end of the first branch 150a and one end of the third branch 150e, and the second connection branch 150d connects one end of the second branch 150b and one end of the third branch 150e. In one embodiment, the first and second connection branches 150c and 150d may be formed as inclined surfaces each having a predetermined inclination. Since an amount of the molding material to be injected in the space between the first branch 150a and the second branch 150b to form the molding member 180 may be increased by forming the first and second connection branches 150c and 150d as the inclined surfaces, an insulation property between the first and second substrates 120 and 130 may be increased.

The one end of the third branch 150e is connected to each of the first and second branches 150a and 150b through the first and second connection branches 150c and 150d, and the other end is electrically connected to an external load.

In the above-described embodiment, it is described that the second lead frame 150 includes the first branch 150a and the second branch 150b, but in the modified embodiment, the second lead frame 150 may include only one of the first branch 150a and the second branch 150b. In this case, the second lead frame 150 may be electrically connected to either the first substrate 120 or the second substrate 130 through the first branch 150a or the second branch 150b. When the second lead frame 150 includes only the first branch 150a, the second connection branch 150d may be omitted, and when the second lead frame 150 includes only the second branch 150b, the first connection branch 150c may be omitted.

In the above-described embodiment, in the first lead frame 140, the first branch 140a, the second branch 140b, the first connection branch 140c, the second connection branch 140d, and the third branch 140e may be formed as one body. In the second lead frame 150, the first branch 150a, the second branch 150b, the first connection branch 150c, the second connection branch 150d, and the third branch 150e may be formed as one body. In this case, each of the first and second lead frames 140 and 150 may be formed in a Y-shape as a whole.

The molding member 180 is formed in the space between the first substrate 120 and the second substrate 130. In one embodiment, the molding member 180 may be formed of an epoxy molding compound (EMC). The molding member 180 increases an insulation distance between the first substrate 120 and the second substrate 130 as well as insulation distances between the semiconductor devices 110a to 110d. Further, the molding member 180 may protect the semiconductor devices 110a to 110d from oxidization materials and perform a function of fixing the semiconductor devices 110a to 110d.

Specifically, when the space between the first substrate 120 and the second substrate 130 is narrow, a problem in that the molding member 180 is not appropriately formed or appropriately distributed, and bubbles are formed in some positions may occur. On the other hand, in the case of the present disclosure, since the circuit line layers 124 and 134 which are formed thickly may replace the existing spacer, the first substrate 120 and the second substrate 130 may be spaced apart from each other at the predetermined distance or more.

Meanwhile, there may be a case in which a circuit pattern formed on the first substrate 120 and a circuit pattern formed on the second substrate 130 should be directly connected to each other as necessary. To this end, the first circuit line layer 124 according to the present disclosure may further include a lower conductive dummy pattern 128, and the second circuit line layer 134 may further include an upper conductive dummy pattern 138.

In one embodiment, the lower conductive dummy pattern 128 may be formed to have a fourth upper thickness UT4 and the upper conductive dummy pattern 138 may be formed to have a fourth upper thickness UT4. The fourth lower thickness LT4 and the fourth upper thickness UT4 may have the same value, but may have different values.

In this case, the fourth lower thickness LT4 may have a different value from at least one of the first to third lower thicknesses LT1 to LT3 and the fourth upper thickness UT4 may have a different value from at least one of the first to third upper thicknesses UL1 to UT3. For example, the fourth lower thickness LT4 may have a different value from all of the first to third lower thicknesses LT1 to LT3 and the fourth upper thickness UT4 may have a different value from all of the first to third upper thicknesses UT1 to UT3.

The lower conductive dummy pattern 128 and the upper conductive dummy pattern 138 may be coupled to each other through a seventh bonding member 190, and in this case, the seventh bonding member 190 may be formed of a conductive material.

In the above embodiment, it is described that the semiconductor module 100 includes the lower conductive dummy pattern 128 and the upper conductive dummy pattern 138, but in another embodiment, the semiconductor module 100 may include only one conductive pattern (not shown) having a fifth thickness between the first substrate 120 and the second substrate 130.

In FIG. 1, for convenience of description, it is described that the semiconductor module 100 includes four semiconductor devices 110a to 110d, but this description is only an example, and the number of semiconductor devices may be variously varied according to an application in which the semiconductor module 100 is used, a type of the semiconductor module 100, or the like. For example, as shown in FIG. 3, a semiconductor module 300 may include only one semiconductor device 110a. Since configurations of the semiconductor module 300 shown in FIG. 3 are the same as those of the semiconductor module 100 shown in FIG. 1 except that the number of semiconductor devices is one, detailed descriptions thereof will be omitted.

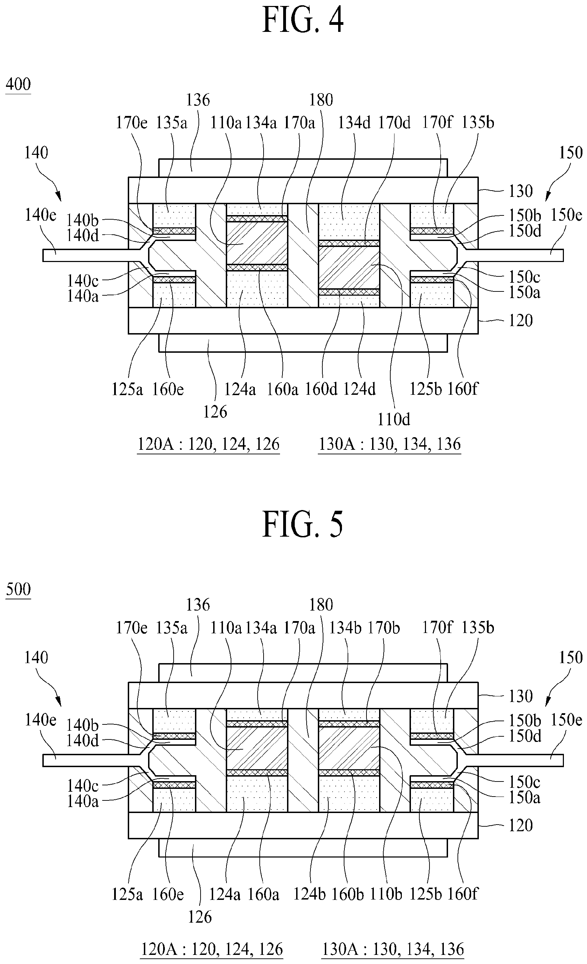

As still another example, as shown in FIG. 4, a semiconductor module 400 may include two semiconductor devices 110a and 110d disposed in opposite directions. Since configurations of the semiconductor module 400 shown in FIG. 4 are the same as those of the semiconductor module 100 shown in FIG. 1 except that the semiconductor module 100 in FIG. 1 includes two pairs of semiconductor devices 110a and 110d, and 110b and 110c disposed in opposite directions, but the semiconductor module 400 in FIG. 4 includes a pair of semiconductor devices 110a and 110d disposed in opposite directions, detailed descriptions thereof will be omitted.

As yet another example, as shown in FIG. 5, a semiconductor module 500 may include two semiconductor devices 110a and 110b disposed in the same direction. Since configurations of the semiconductor module 500 shown in FIG. 5 are the same as those of the semiconductor module 100 shown in FIG. 1 except that the semiconductor module 100 in FIG. 1 includes two pairs of semiconductor devices 110a and 110b, and 110c and 110d disposed in the same direction, but the semiconductor module 500 in FIG. 5 includes a pair of semiconductor devices 110a and 110b disposed in the same direction, detailed descriptions thereof will be omitted.

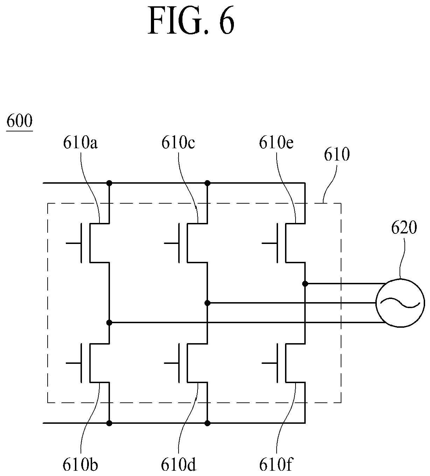

As yet another example, the semiconductor module 100 may include six semiconductor devices. In this case, the semiconductor module 100 may constitute a power device as shown in FIG. 6. As shown in FIG. 6, a power device 600 may include an inverter 610 and a motor 620.

The motor 620 provides power to an electric vehicle, a fuel cell vehicle, or the like. The motor 620 may be driven by receiving three-phase alternating current (AC) power.

The inverter 610 supplies the AC power to the motor 620. The inverter 610 may receive direct current (DC) power from a battery or fuel cell and convert the DC power to the AC power, and then output the converted AC power to the motor 620. As shown in FIG. 6, the inverter 610 may include six semiconductor devices 610a to 610f, and the semiconductor module of the present disclosure including the six semiconductor devices 610a to 610f may serve as the inverter 610 of the power device 600.

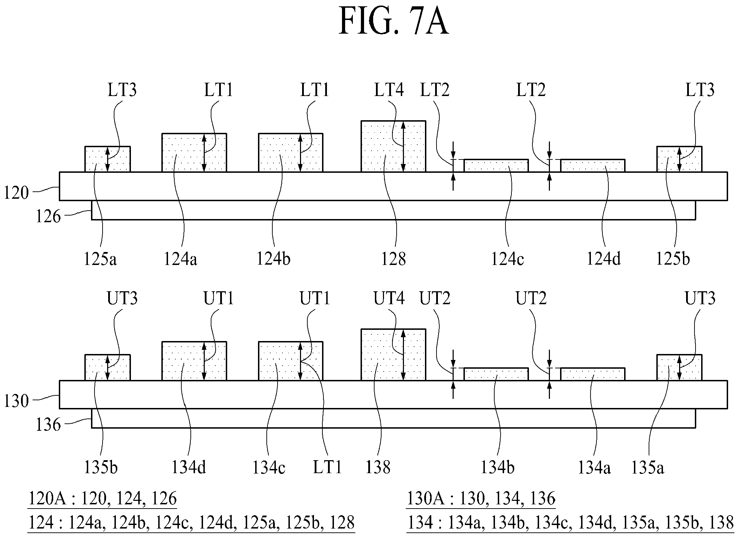

Hereinafter, a method of manufacturing a semiconductor module having a double-sided heat dissipation structure according to the present disclosure will be described with reference to FIGS. 7A to 7D. FIGS. 7A to 7D are schematic cross-sectional views of a process illustrating the method of manufacturing a semiconductor module having a double-sided heat dissipation structure according to one embodiment of the present disclosure.

First, as shown in FIG. 7A, a first circuit line layer 124 including a plurality of lower circuit patterns 124a to 124d and a plurality of lower terminal patterns 125a and 125b is formed on a first surface of the first substrate 120, and a first heat dissipation layer is formed on a second surface of the first substrate 120. Through this, the manufacturing of the first heat dissipation substrate 120A is completed.

In one embodiment, the plurality of lower circuit patterns 124a to 124d include first to fourth lower circuit patterns 124a to 124d. In this case, the number of circuit patterns may be determined according to the number of semiconductor devices to be included in the semiconductor module 100. Further, the plurality of lower terminal patterns 125a and 125b include a first lower terminal pattern 125a and a second lower terminal pattern 125b.

According to this embodiment, the lower circuit patterns 124a to 124d and the lower terminal patterns 125a and 125b may be formed to have different thicknesses, and the lower circuit patterns 124a to 124d may be formed with thicknesses which are different for each position depending on the thickness difference between the semiconductor devices 110a to 110d.

Specifically, as shown in FIG. 7A, the first and second lower circuit patterns 124a and 124b may be formed to have a first lower thickness LT1, and the third and fourth lower circuit patterns 124c and 124d may be formed to have a second lower thickness LT2 different from the first lower thickness LT1. Further, the first and second lower terminal patterns 125a and 125b may be formed to have a third lower thickness LT3 different from the first lower thickness LT1 and the second lower thickness LT2. In one embodiment, the first lower thickness LT1, the second lower thickness LT2, and the third lower thickness LT3 may be varied depending on the interval between the first substrate 120 and the second substrate 130 and thicknesses of the semiconductor devices to be included in the semiconductor module 100. The first lower thickness LT1 of the first and second lower circuit patterns 124a and 124b may be greater than the second lower thickness LT2 of the third and fourth lower circuit patterns 124c and 124d, and the third lower thickness LT3 of the first and second lower terminal patterns 125a and 125b may be smaller than the first lower thickness LT1 and greater than the second lower thickness LT2.

Like the process of forming the first heat dissipation substrate 120A, a second circuit line layer 134 including a plurality of upper circuit patterns 134a to 134d and a plurality of upper terminal patterns 135a and 135b is formed on a first surface of the second substrate 130, and a second heat dissipation layer 136 is formed on a second surface of the second substrate 130. Through this, the manufacturing of the second heat dissipation substrate 130A is completed.

In one embodiment, the plurality of upper circuit patterns 134a to 134d include first to fourth upper circuit patterns 134a to 134d. In this case, the number of upper circuit patterns 134a to 134d may be determined according to the number of semiconductor devices to be included in the semiconductor module 100. Further, the plurality of upper terminal patterns 135a and 135b include a first upper terminal pattern135a and a second upper terminal pattern 135b.

According to this embodiment, the upper circuit patterns 134a to 134d and the upper terminal patterns 135a and 135b may be formed to have different thicknesses, and the upper circuit patterns 134a to 134d may be formed with thicknesses which are different for each position depending on the thickness difference between the semiconductor devices 110a to 110d.

Specifically, as shown in FIG. 7A, the first and second upper circuit patterns 134a and 134b may be formed to have the first upper thickness UT1, and the third and fourth upper circuit patterns 134c and 134d may be formed to have the second upper thickness UT2. Further, the first and second upper terminal patterns 135a and 135b may be formed to have the third upper thickness UT3.

In one embodiment, when the first substrate 120 having the first surface on which a first conductive layer (Not shown) is formed and the second surface on which the first heat dissipation layer 126 is formed, and the second substrate 130 having the first surface on which a second conductive layer (Not shown) is formed and the second surface on which the second heat dissipation layer 136 is formed are provided, by selectively etching the first conductive layer using a halftone mask, the lower circuit patterns 124a to 124d and the lower terminal patterns 125a and 125b having different thicknesses may be formed on the first substrate 120, and by selectively etching the second conductive layer using a halftone mask, the upper circuit patterns 134a to 134d and the upper terminal patterns 135a and 135b having different thicknesses may be formed on the second substrate 130.

As another example, by using a printing technique, the lower circuit patterns 124a to 124d and the lower terminal patterns 125a and 125b having different thicknesses may be formed on the first substrate 120, and the upper circuit patterns 134a to 134d and the upper terminal patterns 135a and 135b having different thicknesses may be formed on the second substrate 130.

In addition to the above-described methods, various methods can be used such as changing the number of etchings depending on the thicknesses of the lower circuit patterns 124a to 124d, the lower terminal patterns 125a and 125b, the upper circuit patterns 134a to 134d, and the upper terminal patterns 135a and 135b as long as the lower circuit patterns 124a to 124d, the lower terminal patterns 125a and 125b, the upper circuit patterns 134a to 134d, and the upper terminal patterns 135a and 135b may have different thicknesses.

In this case, the first upper circuit pattern 134a is formed in a region corresponding to the first lower circuit pattern 124a on the first surface of the second substrate 130 when the first substrate 120 and the second substrate 130 are coupled. The second upper circuit pattern 134b is formed in a region corresponding to the second lower circuit pattern 124b on the first surface of the second substrate 130 when the first substrate 120 and the second substrate 130 are coupled. The third upper circuit pattern 134c is formed in a region corresponding to the third lower circuit pattern 124c on the first surface of the second substrate 130 when the first substrate 120 and the second substrate 130 are coupled. The fourth upper circuit pattern 134d is formed in a region corresponding to the fourth lower circuit pattern 124d on the first surface of the second substrate 130 when the first substrate 120 and the second substrate 130 are coupled. Further, the first upper terminal pattern 135a is formed in a region corresponding to the first lower terminal pattern 125a on the first surface of the second substrate 130 when the first substrate 120 and the second substrate 130 are coupled. The second upper terminal pattern 135b is formed in a region corresponding to the second lower terminal pattern 125b on the first surface of the second substrate 130 when the first substrate 120 and the second substrate 130 are coupled.

Like the above, in the present disclosure, by removing the existing spacer disposed between the first substrate 120 and the second substrate 130 and adjusting the thicknesses of the lower circuit patterns 124a to 124d and the lower terminal patterns 125a and 125b formed on the first substrate 120 and the thicknesses of the upper circuit patterns 134a to 134d and the upper terminal patterns 135a and 135b formed on the second substrate 130, problems such as a flatness problem, a misalignment problem, a bonding failure problem, and the like may be solved.

In the above-described embodiment, the first and second heat dissipation substrates120A and 130A may be formed using a direct bonded copper (DBC) method, an active material brazing (AMB) method, a direct plating copper (DPC) method, or the like. The direct bonded copper (DBC) method refers to a method of forming copper layers on both surfaces of a ceramic substrate by a high-temperature oxidation process, and adjusting a temperature in a nitrogen environment to couple copper to an oxide used in the ceramic substrate. The active material brazing (AMB) method refers to a method of brazing using an intermediate material between the ceramic substrate and a metal layer. The direct plating copper (DPC) method refers to a method of directly depositing and forming copper plating on the ceramic substrate.

Meanwhile, there may be the case in which a circuit pattern formed on the first substrate 120 and a circuit pattern formed on the second substrate 130 should be directly connected to each other as necessary. To this end, a lower conductive dummy pattern 128 may be additionally formed on the first substrate 120 and an upper conductive dummy pattern 138 may be additionally formed on the second substrate 130.

In one embodiment, the lower conductive dummy pattern 128 may be formed to have a fourth lower thickness LT4 and the upper conductive dummy pattern 138 may be formed to have a fourth upper thickness UT4. In this case, the fourth lower thickness LT4 may have a different value from at least one of the first to third lower thicknesses LT1 to LT3 and the fourth upper thickness UT4 may have a different value from at least one of the first to third upper thicknesses UT1 to UT3. For example, the fourth lower thickness LT4 may have a different value from all of the first to third lower thicknesses LT1 to LT3 and the fourth upper thickness UT4 may have a different value from all of the first to third upper thicknesses UT1 to UT3.

In the above embodiment, it is described that the semiconductor module 100 includes the lower conductive dummy pattern 128 and the upper conductive dummy pattern 138, but in another embodiment, the semiconductor module 100 may include only one conductive pattern (not shown) having a fifth thickness.

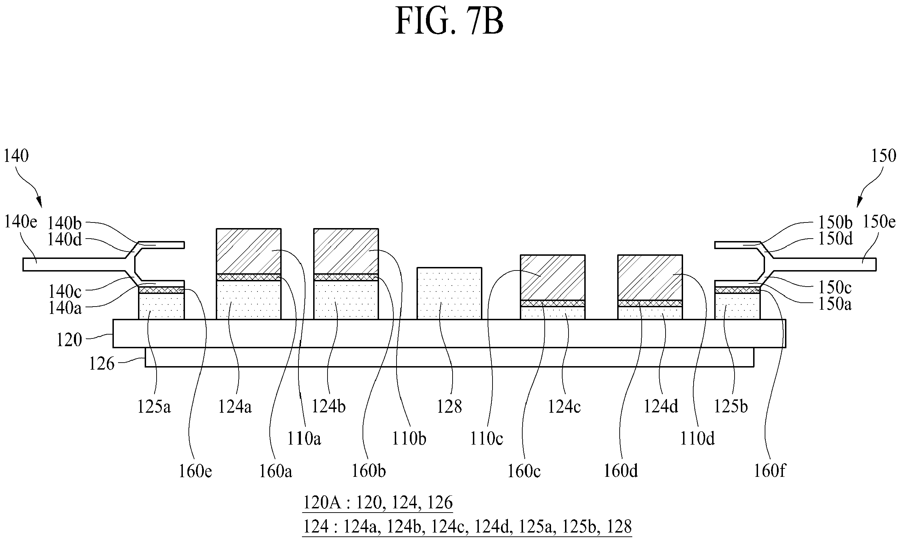

Then, as shown in FIG. 7B, the first to fourth semiconductor devices 110a to 110d are coupled to the first lower circuit patterns 124a to 124d using first to fourth lower bonding members 160a to 160d, and the first lower terminal pattern 125a and the second lower terminal pattern 125b are respectively coupled to the first and second lead frames 140 and 150 using fifth and sixth lower bonding members 160e and 160f.

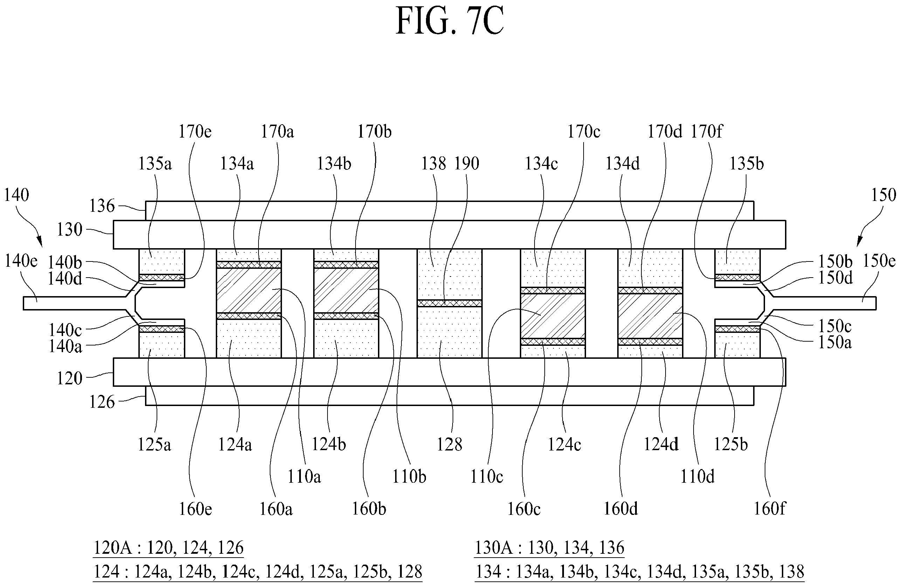

Then, as shown in FIG. 7C, after inverting the second heat dissipation substrate 130A to dispose the second heat dissipation substrate 130A to face the first heat dissipation substrate 120A, the first to fourth upper circuit patterns 134a to 134d are coupled to the first to fourth semiconductor devices 110a to 110d using first to fourth upper bonding members 170a to 170d, and the first upper terminal pattern 135a and the second upper terminal pattern 136b are respectively coupled to the first and second lead frames 140 and 150 using fifth and sixth upper bonding members 170e and 170f.

Like the above, in the case of the present disclosure, since the semiconductor devices 110a to 110d and the lower circuit patterns 124a to 124d are directly coupled through the lower bonding members 160a to 160d and the semiconductor devices 110a to 110d and the upper circuit patterns 134a to 134d are directly coupled through the upper bonding members 170a to 170d without a separate spacer, a crack problem which occurs due to CTE mismatching between the existing spacer and the bonding members may be prevented in advance. Further, since the bonding members for bonding the semiconductor devices and the spacer are not required, the manufacturing process of the semiconductor module is simplified, the structure of the semiconductor module is simplified, and the manufacturing cost of the semiconductor module is reduced, and thus the productivity is improved.

Meanwhile, when the lower conductive dummy pattern 128 is additionally formed on the first substrate 120 and the upper conductive dummy pattern 138 is additionally formed on the second substrate 130, the lower conductive dummy pattern 128 and the upper conductive dummy pattern 138 may be coupled through a seventh bonding member 190, and in this case, the seventh bonding member 190 may be formed of a conductive material.

In the above-described embodiment, the first to fourth semiconductor devices 110a to 110d may be coupled to the first and second substrates 120 and 130 through a soldering technique. Specifically, the first to fourth semiconductor devices 110a to 110d may be soldered to the first and second substrates 120 and 130 by applying heat to the lower bonding members 160a to 160d disposed under the first to fourth semiconductor devices 110a to 110d and the upper bonding members 170a to 170d disposed above the first to fourth semiconductor devices 110a to 110d.

As another example, the first to fourth semiconductor devices 110a to 110d may be coupled to the first and second substrates 120 and 130 through a sintering process of applying heat and pressure or heat to the lower bonding members 160a to 160d and the upper bonding members 170a to 170d composed of an Ag-based material of micro- or nano-sized particles.

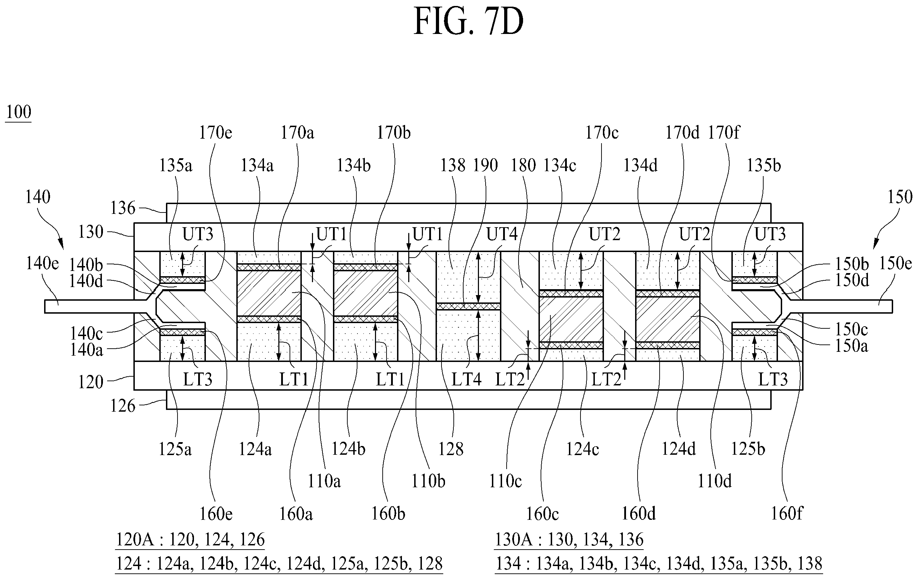

Then, as shown in FIG. 7D, a molding member 180 is formed in a space between the first substrate 120 and the second substrate 130. In one embodiment, the molding member 180 may be formed by injecting an epoxy molding compound (EMC). The molding member 180 may increase an insulation distance between the first substrate 120 and the second substrate 130, protect the first to fourth semiconductor devices 110a to 110d from oxidization materials, and perform a function of fixing the first to fourth semiconductor devices 110a to 1 10d.

According to the present disclosure, since an existing spacer can be replaced by increasing a thickness of circuit patterns formed on a first substrate and a second substrate, an additional process of bonding the spacers is not required and thus a manufacturing process of a semiconductor module is simplified, and a structure of the semiconductor module is also simplified, and accordingly, there is an effect that a cost is reduced and thus productivity is improved.

Further, according to the present disclosure, since circuit patterns to which semiconductor devices are respectively coupled are directly formed on first and second substrates with different thicknesses according to a required space between the first and second substrates or thicknesses of the semiconductor devices to be interposed between the first and second substrates, there is an effect of improving flatness of the semiconductor module while securing an space between the first and second substrates.

In addition, according to the present disclosure, since a spacer is not required, there is an effect that an expensive bonding member for bonding the spacer is not required and thus cost reduction is maximized.

In addition, since the spacer is removed, occurrence of cracks due to a difference in a coefficient of thermal expansion between the spacer and an bonding member can be prevented in advance, and accordingly, there is an effect of improving reliability of the semiconductor module.

It may be understood that those skilled in the art may modify the present invention in other detailed forms without changing the technical spirit or the essential feature.

Therefore, the above-described embodiments should be understood to be exemplary and not limiting in every aspect. The scope of the present disclosure will be defined by the following claims rather than the above-detailed description, and all changes and modifications derived from the meaning and the scope of the claims and equivalents thereof should be understood as being included in the scope of the present disclosure.

## Claims

1. A semiconductor module, comprising:
a first substrate having a plurality of patterns having two or more different thickness;
a first semiconductor device disposed on at least one or more patterns;
a second substrate having a plurality of patterns having two or more different thickness, wherein one or more of the plurality of patterns of the second substrate is placed on the first semiconductor device;
a first terminal pattern and a second terminal pattern, each disposed between the first substrate and the second substrate, wherein the first terminal pattern comprises a first upper terminal pattern and a first lower terminal pattern, and the second terminal pattern comprises a second upper terminal pattern and a second lower terminal pattern; and
a conductive frame coupled to at least one of the first and the second terminal patterns.

2. The semiconductor module of claim 1, wherein the conductive frame includes:
a first branch electrically connected to at least one of the first upper terminal pattern and the first lower terminal pattern; and
a second branch having one end connected to one end of the first branch and the other end extending to the outside of the first and second substrates.

3. The semiconductor module of claim 2, wherein the conductive frame further includes:
a connection branch formed as an inclined surface having a first inclination, and having one end connected to the first branch and the other end connected to the second branch.

4. The semiconductor module of any one of claims 1 to 3, further comprising:
a first lower circuit pattern with a first lower thickness being formed on the first substrate; and
a first upper circuit pattern with a first upper thickness being formed in a region corresponding to the first lower circuit pattern on the second substrate,
wherein the first semiconductor device is coupled to the first lower circuit pattern through a first lower conductive bonding member, and coupled to the first upper circuit pattern through a first upper conductive bonding member.

5. The semiconductor module of claim 4, further comprising:
a second lower circuit pattern with a second lower thickness being formed on the first substrate;
a second upper circuit pattern with a second upper thickness being formed in a region corresponding to the second lower circuit pattern on the second substrate; and
a second semiconductor device being disposed between the second lower circuit pattern and the second upper circuit pattern, and having a first surface, on which a first electrode is formed, connected to the second upper circuit pattern, and having a second surface, on which a second electrode is formed, connected to the second lower circuit pattern,
wherein the second semiconductor device is coupled to the second lower circuit pattern through a second lower conductive bonding member, and coupled to the second upper circuit pattern through a second upper conductive bonding member, and
wherein the conductive frame is coupled to the first lower terminal pattern through a third lower conductive bonding member, and coupled to the first upper terminal pattern through a third upper conductive bonding member.

6. The semiconductor module of any one of claims 1 to 5, further comprising:
a lower conductive dummy pattern with a third lower thickness being formed on the first substrate; and
an upper conductive dummy pattern with the third upper thickness being formed in a region corresponding to the lower conductive dummy pattern on the second substrate,
wherein the lower conductive dummy pattern and the upper conductive dummy pattern are coupled to each other through a fourth conductive bonding member.

7. The semiconductor module of any one of claims 1 to 6, further comprising:
a lower conductive dummy pattern with a fourth thickness being formed between the first substrate and the second substrate.

8. The semiconductor module of any one of claims 1 to 7, further comprising:
a molding member, the molding member being formed between the first substrate and the second substrate.

9. The semiconductor module of any one of claims 1 to 8, wherein the first substrate and the second substrate are formed of an insulating material, and a heat dissipation layer is formed on a second surface of each of the first substrate and the second substrate.

10. The semiconductor module of any one of claims 1 to 9, further comprising:
a first heat dissipation substrate, the first heat dissipation substrate being placed on the first substrate opposite to the plurality of patterns; and
a second heat dissipation substrate, the second heat dissipation substrate being placed on the second substrate opposite to the plurality of patterns.

11. A method of fabricating a semiconductor module comprising:
preparing a first substrate and a second substrate, wherein the first substrate comprises a first surface on which a first conductive layer is formed and a second surface on which a first heat dissipation layer is formed, and the second substrate comprises a first surface on which a second conductive layer is formed and a second surface on which a second heat dissipation layer is formed;
forming a first lower circuit pattern with a first lower thickness and a second lower circuit pattern with a second lower thickness on the first surface of the first substrate by selectively etching the first conductive layer;
forming a first upper circuit pattern with a first upper thickness in a region corresponding to the first lower circuit pattern and a second upper circuit pattern with a second upper thickness in a region corresponding to the second lower circuit pattern on a first surface of a second substrate by selectively etching the second conductive layer;
disposing the first and the second substrates so that each of the first surfaces of the first and the second substrates faces each other;
bonding a first semiconductor device to the first lower circuit pattern and the first upper circuit pattern using a first lower conductive bonding member and a first upper conductive bonding member; and
bonding a second semiconductor device to the second lower circuit pattern and the second upper circuit pattern using a second lower conductive bonding member and a second upper conductive bonding member.

12. The method of claim 11, further comprising:
forming a first lower terminal pattern with a third lower thickness different from the first lower thickness and the second lower thickness on the first surface of the first substrate by selectively etching the first conductive layer; and
forming a first upper terminal pattern with a third upper thickness in a region corresponding to the first lower terminal pattern on the first surface of the second substrate by selectively etching the second conductive layer; and
coupling one end of a conductive frame to the first lower terminal pattern and the first upper terminal pattern using a third lower conductive bonding member and a third upper conductive bonding member.

13. The method of claim 11 or 12, further comprising:
forming a lower conductive dummy pattern with a fourth lower thickness different from the first lower thickness and the second lower thickness on the first surface of the first substrate by selectively etching the first conductive layer;
forming an upper conductive dummy pattern with a fourth upper thickness in a region corresponding to the lower conductive dummy pattern on the first surface of the second substrate by selectively etching the first conductive layer; and
coupling the lower conductive dummy pattern and the upper conductive dummy pattern each other using a fourth conductive bonding member.

14. The method of any one of claims 11 to 13, wherein the first lower circuit pattern and the second lower circuit pattern are formed by selectively etching the first conductive layer using a halftone mask.

15. The method of any one of claims 11 to 14, wherein the first upper thickness and the second upper circuit pattern are formed by selectively etching the second conductive layer using a halftone mask.
